# EUROPÄISCHE PATENTSCHRIFT

(11) **EP 1 722 611 B1**
(45) Veröffentlichungstag und Bekanntmachung des Hinweises auf die Patenterteilung: **09.12.2009**
(21) Anmeldenummer: 06007437.4
(22) Anmeldetag: 07.04.2006
(51) Int. Cl.: H05K 1/02, H05K 1/18

(54) **Elektronisches Gerät mit einer elektrischen Spule**
Electronic device with an electrical coil
Dispositif électronique avec une bobine électrique

(30) Priorität: 25.04.2005 DE 102005019114
(43) Veröffentlichungstag der Anmeldung: 15.11.2006
(73) Patentinhaber: Osram Gesellschaft mit beschränkter Haftung, 81543 München (DE)
(72) Erfinder: Busse, Olaf, 80686 München (DE); Heckmann, Markus, Guangzhou 511495 (CN); Lecheler, Reinhard, 86633 Neuburg/Donau (DE); Lechner, Alfons, 86558 Hohenwart (DE); Mayer, Siegfried, 85452 Moosinning (DE); Pollischansky, Thomas, 86391 Stadtbergen (DE); Rudolph, Bernd, 85659 Forstern (DE); Schemmel, Bernhard, 82234 Wessling (DE); Schmidtmann, Kay, Dr., 81827 München (DE); Schmitt, Harald, 81827 München (DE); Siegmund, Thomas, Dr., 83624 Otterfing (DE); Storm, Arwed, 85221 Dachau (DE); Werni, Horst, 80937 München (DE)

(56) Entgegenhaltungen:
- DE-A1- 10 332 842
- JP-A- 5 121 885
- JP-A- 6 120 057
- JP-A- 2001 015 350
- US-A1- 2004 245 939
- US-B1- 6 577 066

## Beschreibung

### Technisches Gebiet

Die Erfindung betrifft ein elektronisches Gerät mit einer elektrischen Spule, welche auf einem Bauteilereservoir angeordnet ist.

### Stand der Technik

Bei bekannten elektronischen Geräten, insbesondere elektronischen Vorschaltgeräten, welche zumindest eine elektrische Spule aufweisen, ist es stets ein erstrebenswertes Ziel eine Verkleinerung derartiger Geräte durchführen zu können. Durch eine derartige zunehmende Miniaturisierung von elektronischen Vorschaltgeräten werden die leistungsübertragenden Komponenten thermisch immer stärker belastet. Auch die in diesen elektronischen Vorschaltgeräten enthaltenen Induktivitäten erreichen immer höhere Betriebstemperaturen, wodurch ein Kühlen dieser Induktivitäten bzw. eine Wärmereduzierung bei diesen Induktivitäten erforderlich ist, um eine Beschädigung oder Zerstörung der elektronischen Vorschaltgeräte vermeiden zu können.

Es ist z. B. aus DE 103 32 842 A1 (Honsberg-Riedl) bekannt, dass derartige Induktivitäten beispielsweise durch eine Vergussmasse gekühlt werden. Ein wesentlicher Nachteil einer derartigen Vorgehensweise sind die damit verbundenen relativ hohen Kosten. Ein weiterer Nachteil dieser Lösung ist darin zu sehen, dass die mechanische Belastung der Lötstellen, die abhängig von der Vergussmasse beim Durchlaufen von Temperaturzyklen auftreten können. Eine weitere Alternative, thermische Belastungen bei elektronischen Vorschaltgeräten, insbesondere bei den Induktivitäten reduzieren bzw. in den Griff bekommen zu können, ist durch ein Anbringen von Wärmeleitmatten gegeben. Diese Wärmeleitmatten sind derart ausgebildet, dass sie die entstehende Wärme auf naheliegende Gehäuseteile übertragen sollen. Auch diese Lösung ist mit relativ hohen Kosten verbunden. Des Weiteren tritt auch hier das Problem der mechanischen Belastung der Lötstellen auf. Des Weiteren ist es bekannt, Induktivitäten bzw. Drosselspulen mit Lüftervorrichtungen zu kühlen. Auch diese Lösung ist relativ kostenintensiv und weist darüber hinaus auch noch die Nachteile auf, dass eine erhebliche Geräuschentwicklung vorhanden ist und gegebenenfalls eine reduzierte Lebensdauer einhergeht.

### Darstellung der Erfindung

Daher ist es Aufgabe der vorliegenden Erfindung ein elektronisches Gerät mit einer elektrischen Spule zu schaffen, bei welchem ein Überhitzen der Bauteile verhindert werden kann und dadurch eine Beschädigung oder Zerstörung des elektronischen Geräts vermieden werden kann. Diese Aufgabe wird durch ein elektronisches Gerät, welches die Merkmale nach Patentanspruch 1 aufweist, gelöst.

Ein erfindungsgemäßes elektronisches Gerät umfasst zumindest eine elektrische Spule, welche auf einem Bauteilereservoir angeordnet ist. Ein wesentlicher Gedanke der Erfindung besteht darin, dass das elektronische Gerät Mittel aufweist, welche derart ausgebildet sind, dass eine von der elektrischen Spule erzeugte Wärme von dieser elektrischen Spule über das Bauteilereservoir ableitbar ist. Mit dem erfindungsgemäßen elektronischen Gerät kann erreicht werden, dass die beim Betrieb des elektronischen Geräts, insbesondere beim Betrieb der elektrischen Spule, erzeugte Wärme in optimierter Weise abgeführt werden kann. Indem erfindungsgemäß die Mittel derart ausgebildet und angeordnet sind, dass ein Wärmetransport von der Spule über das Bauteilereservoir erfolgt, kann der Wärmetransport relativ effizient erfolgen, wodurch ein Überhitzen der elektrischen Spule bzw. benachbarter Bauelemente verhindert werden kann. Dadurch kann auch bei immer kleiner ausgebildeten elektronischen Geräten, bei denen die Bauteile immer näher zueinander angeordnet sind, ein Beschädigen oder Zerstören aufgrund einer Überhitzung verhindert werden. Darüber hinaus kann durch die erfindungsgemäße Ausgestaltung des elektronischen Geräts eine relativ kostengünstige Realisierung eines effizienten Wärmetransports bereitgestellt werden. Ferner kann auch eine mechanische Belastung der Lötstellen vermindert bzw. ausgeschlossen werden und eine Geräuschentwicklung, wie dies im Stand der Technik mit einer Lüfterkühlung auftritt, vermieden werden.

Erfindungsgemäß ist um einen Spulenkörper eine erste Wicklung zur elektrischen Funktion der elektrischen Spule und zumindest eine Zusatzwicklung um den Spulenkörper angeordnet sein, welche zum Wärmetransport von der Spule zum Bauteilereservoir ausgebildet ist und ohne elektrische Funktion ist. Somit sind um den Spulenkörper zumindest zwei Wicklungen angeordnet, wobei eine zur elektrischen Funktion der Spule erforderlich ist und die zweite ohne eine derartige elektrische Funktion ist und lediglich zum Wärmetransport von der durch die elektrische Spule im Betrieb erzeugten Wärme zum Bauteilereservoir ausgebildet ist.

In vorteilhafter Weise sind die Mittel zum Ableiten der Wärme derart ausgebildet, dass die Temperatur der elektrischen Spule im Betrieb um mindestens einen Wert von 3°C, insbesondere um einen Wert von 5 °C bis 10°C, reduzierbar ist. Die Mittel sind somit derart ausgebildet, dass sie in bevorzugter Weise eine derartige Temperaturreduzierung der elektrischen Spule bzw. des elektronischen Geräts bewirken, welche ein Beschädigen oder Beeinträchtigen der Betriebsweise des elektronischen Geräts im Betrieb verhindern. Darüber hinaus sind diese Mittel auch derart ausgebildet, dass sie im Hinblick auf eine optimierte Temperaturreduzierung, eine optimierte Kostengestaltung sowie einen optimierten Platzbedarf ausgebildet sind.

In einer vorteilhaften Ausgestaltung ist die elektrische Spule als Drosselspule ausgebildet und ein Spulenkörper der Drosselspule ist aus einem wärmeleitfähigen Material ausgebildet. Dadurch kann erreicht werden, dass durch das Spulenmaterial selbst ein relativ guter Wärmetransport der beim Betrieb der Drosselspule erzeugten Wärme ermöglicht werden kann. In vorteilhafter Weise ist die Wärmeleitfähigkeit des Materials des Spulenkörpers größer oder gleich 1W/mK. Derartige Materialen erlauben eine relativ schnelle Abfuhr der erzeugten Wärme.

Es kann vorgesehen sein, dass an den freien Anschlüssen der elektrischen Spule Metallpins ausgebildet sind, wobei die elektrische Spule mittels der Metallpins mit dem Bauteilereservoir mechanisch verbunden ist. Dadurch kann nochmals eine verbesserte Wärmeübertragung erreicht werden und die Wärme vom Spulenkörper kann besser auf das Bauteilereservoir übertragen werden. Das Bauteilereservoir ist in bevorzugter Weise als Platine ausgebildet.

Es kann vorgesehen sein, dass die Zusatzwicklung benachbart zur ersten Wicklung um den Spulenkörper angeordnet ist. Es kann auch vorgesehen sein, dass die Zusatzwicklung zusätzlich oder anstatt der benachbarten Anordnung zur ersten Wicklung zumindest teilweise auf der ersten Wicklung angeordnet ist. In vielfältiger und flexibler Weise kann somit situationsabhängig und abhängig von der jeweils erforderlichen Ausgestaltung des elektronischen Geräts sowie der elektrischen Spule ein Anordnen der ersten und der zweiten Wicklung durchgeführt werden.

Eine weitere vorteilhafte Ausgestaltung des erfindungsgemäßen elektronischen Geräts weist ein Wärmetransportelement auf, welches zumindest teilweise um eine erste Wicklung der elektrischen Spule angeordnet ist, wobei diese erste Wicklung zur elektrischen Funktion der elektrischen Spule erforderlich ist. Mittels dem Wärmetransportelement kann somit in effizienter Weise die beim Betrieb der elektrischen Spule erzeugte Wärme an das Bauteilereservoir abgeführt werden. Es kann vorgesehen sein, dass das Wärmetransportelement zumindest teilweise an die erste Wicklung angeformt ist. Dadurch kann einerseits erreicht werden, dass in optimaler Weise ein Wärmetransport durchgeführt werden kann und darüber hinaus ein möglichst geringer Platzbedarf für das Wärmetransportelement erforderlich ist.

Es kann darüber hinaus vorgesehen sein, dass das Wärmetransportelement mit dem Bauteilereservoir mechanisch verbunden ist, insbesondere mit einer Lötverbindung an dem Bauteilereservoir befestigt ist. Dies gewährleistet einerseits eine mechanisch besonders stabile Anordnung und ermöglicht andererseits eine besonders effektive und effiziente Wärmeübertragung an das Bauteilereservoir. Das Wärmetransportelement ist in vorteilhafter Weise als Metallblech ausgebildet.

Es kann des Weiteren vorgesehen sein, dass das Wärmetransportelement zumindest ein Kühlelement aufweist, welches sich zumindest teilweise in horizontaler Richtung neben der elektrischen Spule erstreckt und beabstandet zum Bauteilereservoir angeordnet ist.

In vorteilhafter Ausführung ist das erfindungsgemäße elektronische Gerät als elektronisches Vorschaltgerät ausgebildet, welches insbesondere für Lampen, insbesondere für Leuchtstofflampen, ausgebildet ist.

### Kurze Beschreibung der Zeichnungen

Ausführungsbeispiele der Erfindung werden nachfolgend anhand schematischer Zeichnungen näher erläutert. Es zeigen:
- Figur 1: eine Schnittdarstellung durch ein erstes Ausführungsbeispiel eines erfindungsgemäßen elektronischen Geräts; und
- Figur 2: eine Schnittdarstellung eines zweiten Ausführungsbeispiels eines erfindungsgemäßen elektronischen Geräts.

### Bevorzugte Ausführung der Erfindung

In den Figuren werden gleiche oder funktionsgleiche Elemente mit den selben Bezugszeichen versehen.

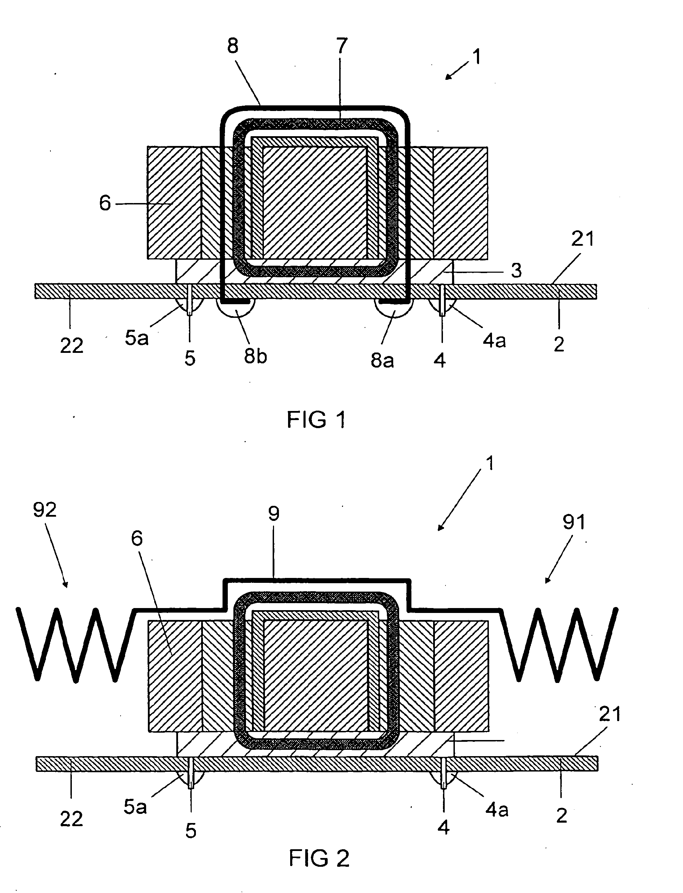

In Figur 1 ist eine Querschnittdarstellung eines ersten Ausführungsbeispiels eines erfindungsgemäßen elektronischen Geräts gezeigt. Das elektronische Gerät ist in diesem Ausführungsbeispiel als elektronisches Vorschaltgerät 1 für Leuchtstofflampen ausgebildet. Das elektronische Vorschaltgerät 1 ist auf einem im Ausführungsbeispiel als Platine 2 ausgebildeten Bauteilereservoir angeordnet. Das elektronische Vorschaltgerät 1 weist eine Drosselspule auf, welche im Ausführungsbeispiel einen Spulenkörper 3 aufweist, welcher auf der Oberseite 21 der Platine 2 angeordnet ist. Der Spulenkörper 3 ist im Ausführungsbeispiel aus einem wärmeleitfähigen Material ausgebildet, welches eine Wärmeleitfähigkeit von mindestens 1 W/mK aufweist. Wie des Weiteren aus der Darstellung in Figur 1 zu erkennen ist, sind die freien Anschlüsse der Drosselspule mit Metallpins 4 und 5 versehen, welche durch Aussparungen in der Platine 2 hindurchragen und auf der Unterseite 22 der Platine 2 mittels Lötverbindungen 4a bzw. 5a mechanisch fest mit der Platine 2 verbunden sind. Diesbezüglich ist auch der Spulenkörper 3 fest mit der Platine 2 verbunden.

Wie des Weiteren aus der Darstellung in Figur 1 zu erkennen ist, ist der Spulenkörper 3 bzw. die Drosselspule zumindest teilweise von einem Element 6 umgeben, welches im Ausführungsbeispiel aus Ferrit ausgebildet ist. Das elektronische Vorschaltgerät 1 bzw. die Drosselspule umfasst eine nicht dargestellte erste Wicklung, welche für das Funktionsprinzip der Drosselspule erforderlich ist. Diese erste Wicklung hat somit eine elektrische Funktion. Des Weiteren umfasst die Drosselspule zumindest eine zweite Wicklung 7, welche um den Spulenkörper gewickelt ist und als Zusatzwicklung ausgebildet ist. Diese Zusatzwicklung bzw. zweite Wicklung 7 weist keine elektrische Funktion auf und dient dazu, im Betrieb der Drosselspule erzeugte Wärme auf die Platine 2 abzuleiten. Die Zusatzwicklung bzw. die zweite Wicklung 7 kann benachbart zur ersten Wicklung um den Spulenkörper gewickelt sein. Es kann jedoch auch vorgesehen sein, dass die zweite Wicklung 7 zusätzlich oder anstatt einem benachbarten Anordnen zur ersten Wicklung zumindest teilweise auf der ersten Wicklung angeordnet ist.

Zum optimierten Wärmetransport von der Drosselspule zur Platine 2 ist im Ausführungsbeispiel gemäß Figur 1 des Weiteren ein als Metallblech ausgebildetes Wärmetransportelement 8a angeordnet. Wie aus der Querschnittdarstellung zu erkennen ist, ist das Wärmetransportelement 8a haubenförmig um die zweite Wicklung 7 sowie zumindest teilweise um den Spulenkörper 3 der Drosselspule angeordnet. Das Wärmetransportelement 8a ist somit zumindest teilweise an die zweite Wicklung 7 angeformt. Wie in Figur 1 zu erkennen ist, ist das Wärmetransportelement 8a mit seinen freien Enden durch Aussparungen in der Platine 2 hindurchgeführt und an der Unterseite 22 der Platine 2 mit Lötverbindungen 8a und 8b befestigt. Wie aus der Darstellung in Figur 1 zu erkennen ist, sind die freien Enden des Wärmetransportelements 8 umgebogen und im Wesentlichen parallel zur Unterseite 22 der Platine 2 orientiert. Diese beiden umgebogenen Bereiche sind dabei derart orientiert, dass sie einander zugewandt ausgebildet sind.

Mit der in Figur 1 gezeigten Ausführung der Erfindung kann ein optimierter Wärmetransport in dem elektronischen Vorschaltgerät 1 erzielt werden. Diesbezüglich sei angemerkt, dass im Ausführungsbeispiel gemäß Figur 1 mehrere Alternativen von erfindungsgemäßen Mitteln zum Wärmetransport von der Drosselspule zur Platine ausgebildet sind. Diese Mittel umfassen in dem Ausführungsbeispiel in Figur 1 einerseits einen aus einem wärmeleitfähigen Material bestehenden Spulenkörper 3, darüber hinaus mit Metallpins 4 und 5 versehene freie Anschlüsse der Drosselspule, sowie als weitere Alternativen die zweite Wicklung 7 sowie das Wärmetransportelement 8. Es sei angemerkt, dass jede dieser vier Alternativen für sich alleine bereits einen verbesserten und erfindungsgemäßen Wärmetransport von der Drossel hin zur Platine 2 ermöglicht. Des Weiteren sei angemerkt, dass die erfindungsgemäßen Mittel zum Wärmetransport von der Drosselspule zur Platine 2 durch eine beliebige Kombination der im Ausführungsbeispiel gemäß Figur 1 genannten vier erfindungsgemäßen Alternativen ermöglicht werden kann. Wie bereits erwähnt, kann diesbezüglich jede Alternative für sich allein gesehen bereits das erfindungsgemäße Konzept realisieren. Darüber hinaus kann eine beliebige Kombination von zwei aber auch drei der im Ausführungsbeispiel gemäß Figur 1 ausgebildeten Alternativen in einem elektronischen Vorschaltgerät 1 vorgesehen sein. Beispielsweise kann diesbezüglich vorgesehen sein, dass der Spulenkörper 3 aus einem wärmeleitfähigen Material ist und als zweite Alternative hinzu lediglich noch ein Wärmetransportelement 8 angeordnet ist. Es kann jedoch auch vorgesehen sein, dass der Spulenkörper 3 mit Metallpins 4 und 5 versehene freie Anschlüsse aufweist und des Weiteren eine ohne elektrische Funktion ausgebildete zweite Wicklung 7 zum Wärmetransport angeordnet ist. Weitere Kombinationen können aus den in Figur 1 realisierten vier Alternativen erzeugt werden.

In Figur 2 ist in einer Querschnittdarstellung ein zweites Ausführungsbeispiel eines erfindungsgemäßen elektronischen Geräts mit einer elektrischen Spule gezeigt. Auch in diesem Ausführungsbeispiel ist das elektronische Gerät als elektronisches Vorschaltgerät 1 ausgebildet. In dem in Figur 2 gezeigten Ausführungsbeispiel weist das elektronische Vorschaltgerät 1 ein Wärmetransportelement 9 auf. Im Unterschied zum Wärmetransportelement 8 gemäß Figur 1 weist dieses Wärmetransportelement 9 keine mechanische Verbindung mit der Platine 2 auf. Wie aus der Darstellung in Figur 2 zu erkennen ist, erstreckt sich das Wärmetransportelement 9 oberhalb der zweiten Wicklung 7 sowie dem Spulenkörper 3 und dem Ferritelement 6. Das Wärmetransportelement 9 ist lediglich im mittigen Bereich im oberen Bereich der zweiten Wicklung 7 an die zweite Wicklung 7 angeformt. Seitlich der Drosselspule bzw. des Spulenkörpers 3 sowie des Ferritelements 6 weist das Wärmetransportelement 9 ein erstes Kühlelement 91 und ein zweites Kühlelement 92 auf. Die Kühlelemente 91 und 92 sind in ihrer Querschnittdarstellung zackenförmig ausgebildet. Die Kühlelemente 91 und 92 ermöglichen einen Wärmetransport vom Spulenkörper 3 an die Umgebung. Dadurch kann erreicht werden, dass zusätzlich zur Wärmeübertragung vom Spulenkörper 3 bzw. von der Drosselspule auf die Platine 2 eine Wärmeübertragung von der Drosselspule bzw. vom Spulenkörper 3 über das Wärmetransportelement 9 bzw. die Kühlelemente 91 und 92 an die Umgebung erfolgt.

Auch im Ausführungsbeispiel gemäß Figur 2 sei angemerkt, dass eine beliebige Kombination der Alternativen zum optimierten Wärmetransport von der elektrischen Spule weg realisiert sein kann.

Durch die Erfindung kann erreicht werden, dass die Temperatur der elektrischen Spule bzw. der Drosselspule des elektronischen Vorschaltgeräts 1 im Betrieb um einen Wert von 3°C bis 12°C, insbesondere um einen Wert von 5°C bis 10°C reduziert werden kann. Eine derartige Temperaturreduzierung ist in zweierlei Hinsicht optimal, denn die Mittel sind derart ausgebildet, dass sie eine kostengünstige und platzsparende Realisierung für eine Temperaturreduzierung der elektrischen Spule bzw. des elektronischen Geräts ermöglichen und andererseits diesbezüglich die Temperaturreduzierung im Wesentlichen um einen derartigen Wert erfolgt, dass ein Überhitzen und somit Beschädigen oder Zerstören der Komponenten des elektronischen Geräts und somit des elektronischen Geräts selbst verhindert werden kann.

## Patentansprüche

1. Elektronisches Gerät mit einer elektrischen Spule, welche auf einem Bauteilereservoir (2) angeordnet ist,
wobei das elektronische Gerät Mittel (4, 5; 7; 8; 9, 91, 92) aufweist, welche derart ausgebildet sind, dass eine von der elektrischen Spule erzeugte Wärme von der elektrischen Spule über das Bauteilereservoir ableitbar ist,
wobei die elektrische Spule einen Spulenkörper (3) aufweist, um den eine erste Wicklung zur elektrischen Funktion der elektrischen Spule angeordnet ist
wobei die elektrische Spule **dadurch gekennzeichnet ist, dass**
zumindest eine Zusatzwicklung (7) um den Spulenkörper (3) angeordnet ist, welche zum Wärmetransport von der elektrischen Spule zum Bauteilereservoir (2) ausgebildet ist und welche ohne eine elektrische Funktion ist, wobei der Spulenkörper (3) aus einem wärmeleitfähigen Material ist.

2. Elektronisches Gerät nach Anspruch 1
**dadurch gekennzeichnet, dass**
die elektrische Spule eine Drosselspule ist.

3. Elektronisches Gerät nach Anspruch 2,
**dadurch gekennzeichnet, dass**
die Wärmeleitfähigkeit des Materials des Spulenkörpers (3) größer oder gleich 1W/mK ist.

4. Elektronisches Gerät nach einem der vorhergehenden Ansprüche,
**dadurch gekennzeichnet, dass**
an den freien Anschlüssen der elektrischen Spule Metallpins (4, 5) ausgebildet sind, wobei die elektrische Spule mittels der Metallpins (4, 5) mit dem Bauteilereservoir (2) mechanisch verbunden ist.

5. Elektronisches Gerät nach einem der vorigen Ansprüche,
**dadurch gekennzeichnet, dass**
die Zusatzwicklung (7) benachbart zur ersten Wicklung und/oder zumindest teilweise auf der ersten Wicklung angeordnet ist.

6. Elektronisches Gerät nach einem der vorhergehenden Ansprüche,
**dadurch gekennzeichnet, dass**
ein Wärmetransportelement (8; 9) zumindest teilweise um die erste Wicklung der elektrischen Spule angeordnet ist.

7. Elektronisches Gerät nach Anspruch 6,
**dadurch gekennzeichnet, dass**
das Wärmetransportelement (8; 9) zumindest teilweise an die erste Wicklung angeformt ist.

8. Elektronisches Gerät nach Anspruch 6 oder 7,
**dadurch gekennzeichnet, dass**
das Wärmetransportelement (8; 9) mit dem Bauteilereservoir (2) mechanisch verbunden ist, insbesondere mit einer Lötverbindung (8a, 8b) an dem Bauteilereservoir (2) befestigt ist.

9. Elektronisches Gerät nach einem der Ansprüche 6 bis 8,
**dadurch gekennzeichnet, dass**
das Wärmetransportelement (8; 9) als Metallblech ausgebildet ist.

10. Elektronisches Gerät nach Anspruch 6 oder 7,
**dadurch gekennzeichnet, dass**
das Wärmetransportelement (8; 9) zumindest ein Kühlelement (91, 92) aufweist, welches sich zumindest teilweise in horizontaler Richtung neben der elektrischen Spule erstreckt und beabstandet zum Bauteilereservoir (2) angeordnet ist.

11. Elektronisches Gerät nach einem der vorhergehenden Ansprüche,
**dadurch gekennzeichnet, dass**
das elektronische Gerät ein elektronisches Vorschaltgerät (1), insbesondere für Lampen ist.

## Claims

1. Electronic device having an electrical coil, which is arranged on a component reservoir (2), the electronic device having means (4, 5; 7; 8; 9, 91, 92) which are designed such that heat generated by the electrical coil can be conducted away from the electrical coil via the component reservoir, the electrical coil having a coil former (3), around which a first winding is arranged for the electrical function of the electrical coil, the electrical coil being **characterized in that** at least one additional winding (7) is arranged around the coil former (3), which additional winding (7) is designed for heat transfer from the electrical coil to the component reservoir (2) and has no electrical function, the coil former (3) being made from a thermally conductive material.

2. Electronic device according to Claim 1, **characterized in that** the electrical coil is an induction coil.

3. Electronic device according to Claim 2, **characterized in that** the thermal conductivity of the material of the coil former (3) is greater than or equal to 1 W/mK.

4. Electronic device according to one of the preceding claims, **characterized in that** metal pins (4, 5) are formed at the free connections of the electrical coil, the electrical coil being mechanically connected to the component reservoir (2) by means of the metal pins (4, 5).

5. Electronic device according to one of the preceding claims, **characterized in that** the additional winding (7) is arranged adjacent to the first winding and/or at least partially on the first winding.

6. Electronic device according to one of the preceding claims, **characterized in that** a heat-transfer element (8; 9) is arranged at least partially around a first winding of the electrical coil.

7. Electronic device according to Claim 6, **characterized in that** the heat-transfer element (8; 9) is at least partially integrally formed on the first winding.

8. Electronic device according to Claim 6 or 7, **characterized in that** the heat-transfer element (8; 9) is mechanically connected to the component reservoir (2), in particular is fixed to the component reservoir (2) by means of a soldered joint (8a, 8b).

9. Electronic device according to one of Claims 6 to 8, **characterized in that** the heat-transfer element (8; 9) is in the form of a metal sheet.

10. Electronic device according to Claim 6 or 7, **characterized in that** the heat-transfer element (8; 9) has at least one cooling element (91, 92), which extends at least partially in the horizontal direction adjacent to the electrical coil and is arranged such that it is spaced apart from the component reservoir (2).

11. Electronic device according to one of the preceding claims, **characterized in that** the electronic device is an electronic ballast (1), in particular for lamps.

## Revendications

1. Appareil électronique ayant une bobine électrique qui est disposée sur un réservoir ( 2 ) de composant,
dans lequel l'appareil électronique a des moyens ( 4, 5 ; 7 ; 8 ; 9, 91, 92 ) constitué de façon à ce qu'une chaleur produite par la bobine électrique puisse être évacuée de la bobine électrique par le réservoir de composant,
dans lequel la bobine électrique a un corps ( 3 ) de bobine autour duquel est disposé un premier enroulement pour la fonction électrique de la bobine électrique,
dans lequel la bobine électrique est **caractérisée en ce que** au moins un enroulement ( 7 ) supplémentaire est disposé autour du corps ( 3 ) de la bobine, est constitué pour le transport de la chaleur de la bobine électrique au réservoir ( 2 ) de composant et est sans une fonction électrique, le corps ( 3 ) de la bobine étant en un matériau conducteur de la chaleur.

2. Appareil électronique suivant la revendication 1, **caractérisé**,
lorsque la bobine électrique est une bobine de self.

3. Appareil électronique suivant la revendication 2, **caractérisé en ce que** la conductibilité thermique du matériau du corps ( 3 ) de la bobine est inférieure ou égale à 1W/mK.

4. Appareil électronique suivant l'une des revendications précédentes,
**caractérisé en ce que** des broches ( 4, 5 ) ) métalliques sont constituées sur les bornes libres de la bobine électrique, la bobine électrique étant reliée mécaniquement au réservoir ( 2 ) de composant au moyen des broches ( 4, 5 ) métalliques.

5. Appareil électronique suivant l'une des revendications ci-dessus,
**caractérisé en ce que** l'enroulement ( 7 ) supplémentaire est disposé au voisinage du premier enroulement et/ou au moins en partie sur le premier enroulement.

6. Appareil électronique suivant l'une des revendications précédentes,
**caractérisé en ce qu'**un élément ( 8, 9 ) de transport de la chaleur est disposé au moins en partie autour du premier enroulement de la bobine électrique.

7. Appareil électronique suivant la revendication 6,
**caractérisé en ce que** l'élément ( 8, 9 ) de transport de la chaleur est formé au moins en partie sur le premier enroulement.

8. Appareil électronique suivant la revendication 6 ou 7,
**caractérisé en ce que** l'élément ( 8, 9 ) de transport de la chaleur est relié mécaniquement au réservoir ( 2 ) de composant, en étant notamment fixé au réservoir ( 2 ) de composant par un joint ( 8a, 8b ) brasé.

9. Appareil électronique suivant l'une des revendications 6 à 8,
**caractérisé en ce que** l'élément ( 8, 9 ) de transport de la chaleur est constitué sous la forme d'une tôle métallique.

10. Appareil électronique suivant la revendication 6 ou 7,
**caractérisé en ce** l'élément ( 8, 9 ) de transport de la chaleur a au moins un élément ( 91, 92 ) de refroidissement, qui s'étend au moins en partie dans la direction horizontale à côté de la bobine électrique et qui est disposé à distance du réservoir ( 2 ) de composant.

11. Appareil électronique suivant l'une des revendications précédentes,
**caractérisé en ce que** l'appareil électronique est un ballast ( 1 ) électronique, notamment pour des lampes.
